# EUROPEAN PATENT APPLICATION

(11) **EP 4 703 179 A1**
(43) Date of publication of application: **04.03.2026**
(21) Application number: 25190380.3
(22) Date of filing: 18.07.2025
(51) Int. Cl.: B60L 3/00, B60L 3/12, B60L 50/64, B60L 58/10, B60L 58/21, B60L 58/24, H01M 10/42, H01M 10/48

(54) **ABNORMALITY DETERMINATION SYSTEM, VEHICLE, ABNORMALITY DETERMINATION METHOD, AND SERVER**

(30) Priority: 26.08.2024 JP 2024144330; 23.04.2025 JP 2025071431
(71) Applicant: TOYOTA JIDOSHA KABUSHIKI KAISHA, Toyota-shi, Aichi-ken 471-8571 (JP)
(72) Inventor: SASAKI, Manabu, Aichi-ken, 471-8571 (JP); KURODA, Yasuhiro, Aichi-ken, 471-8571 (JP); FUTAMI, Issei, Aichi-ken, 471-8571 (JP); ANDO, Takashi, Aichi-ken, 471-8571 (JP); YOSHIDA, Hiroshi, Aichi-ken, 471-8571 (JP); YOSHIDA, Katsumasa, Aichi-ken, 471-8571 (JP); KAMESAKI, Daisuke, Aichi-ken, 471-8571 (JP); ITO, Shuta, Aichi-ken, 471-8571 (JP); OMAE, Ryoma, Aichi-ken, 471-8571 (JP); YOKOYAMA, Daiki, Aichi-ken, 471-8571 (JP)
(74) Representative: D Young & Co LLP

(57) **Abstract**

An abnormality determination system includes: a battery pack (100); a first acquisition device (351) that acquires a first temperature indicating a temperature of a first region (361) of the battery pack; a second acquisition device (354) that acquires a second temperature indicating a temperature of a second region (364) different from the first region (361); and a control device (402) that determines whether an abnormality has occurred inside or outside the battery pack (100) using information about a history of the first temperature and a history of the second temperature.

## Description

### CROSS REFERENCE TO RELATED APPLICATIONS

This nonprovisional application is based on Japanese Patent Application No. 2024-144330 filed on August 26, 2024 and Japanese Patent Application No. 2025-071431 filed on April 23, 2025, with the Japan Patent Office, the entire contents of which are hereby incorporated by reference.

### BACKGROUND

### Field

The present disclosure relates to an abnormality determination system.

### Description of the Background Art

Techniques are known for detecting the temperature of each cell in a battery pack including a plurality of battery cells. For example, Japanese Patent Laying-Open No. 2008-198515 discloses a technique for detecting the temperatures of a plurality of battery cells by moving a thermistor by use of a servo mechanism.

### SUMMARY

When an abnormal temperature increase is detected in a battery pack configured as described above, it is required to determine with high accuracy whether the abnormal temperature increase is due to a malfunction in the battery pack or due to a change in an external environment of the battery pack.

An object of the present disclosure is to provide an abnormality determination system, a vehicle, an abnormality determination method, and a server capable of determining a cause of a temperature increase with high accuracy.

A battery system according to an aspect of the present disclosure includes: a battery cell; a housing that houses the battery cell and that is mounted on a vehicle; a first detection device that detects a first temperature indicating a temperature of the housing; a second detection device that detects a second temperature indicating a temperature in the housing; and a first control device that compares a result of detection by the first detection device with a result of detection by the second detection device to determine whether a temperature increase in the battery cell is due to a change in an external environment of the housing or due to a malfunction in the battery cell.

Thus, it is possible to use the result of detection by the first detection device and the result of detection by the second detection device to distinguish whether the temperature increase in the battery cell is due to a change in the external environment or due to a malfunction in the battery cell, to thereby determine the cause of the abnormal temperature increase with high accuracy.

In an embodiment, when a first rate of increase in the first temperature is higher than a second rate of increase in the second temperature, the first control device determines that the temperature increase is due to a change in the external environment, and when the second rate of increase is higher than the first rate of increase, the first control device determines that the temperature increase is due to a malfunction in the battery cell.

Thus, it is possible to distinguish with high accuracy whether the temperature increase in the battery cell is due to a change in the external environment or due to a malfunction in the battery cell.

In a further embodiment, the battery system further includes a second control device capable of communicating with a server external to the vehicle. The first control device activates the second control device to transmit, to the server, information from which a result of determination can be acquired.

Thus, since the information from which the result of determination can be acquired can be saved on the server, the result of determination of the cause of the temperature increase can be acquired on the server side.

In a further embodiment, the first detection device is provided at a position other than on a path along which gas is discharged out of the housing from the battery cell upon generation of the gas in the battery cell.

Thus, when gas is generated in the battery cell, the effect of the generated gas on the detection of the first temperature by use of the first detection device is suppressed.

In a further embodiment, a plurality of battery cells are housed in the housing. An insulating plate that provides insulation between the battery cells is provided between the battery cells. The first detection device is provided in a lower portion of the insulating plate.

Thus, since the first detection device is provided in the lower portion of the insulating plate, the first detection device can be readily assembled to the battery cell.

An abnormality determination system according to another aspect of the present disclosure includes: a battery pack; a first acquisition device that acquires a first temperature indicating a temperature of a first region of the battery pack; a second acquisition device that acquires a second temperature indicating a temperature of a second region different from the first region; and a control device that determines whether an abnormality has occurred inside or outside the battery pack using information about a history of the first temperature and a history of the second temperature.

Thus, it is possible to determine with high accuracy whether the abnormality has occurred inside or outside the battery pack by using the history of the first temperature and the history of the second temperature.

In an embodiment, when a predetermined change occurs in each of the first temperature and the second temperature, the control device determines that the abnormality has occurred outside the battery pack, and when the predetermined change occurs in one of the first temperature and the second temperature, the control device determines that the abnormality has occurred inside the battery pack.

Thus, the change occurs in both the first temperature and the second temperature when the abnormality occurs outside the battery pack, and the change occurs in one of the first temperature and the second temperature when the abnormality occurs inside the battery pack. It is thus possible to determine with high accuracy whether the abnormality has occurred inside or outside the battery pack.

In a further embodiment, the abnormality determination system further includes a third acquisition device that acquires a third temperature indicating a temperature of a third region of the battery pack. When a number of the first temperature, the second temperature and the third temperature in which a predetermined change has occurred exceeds a predetermined value, the control device determines that the abnormality has occurred outside the battery pack, and when the number of the temperatures in which the predetermined change has occurred is smaller than or equal to the predetermined value, the control device determines that the abnormality has occurred inside the battery pack.

Thus, it is possible to determine with high accuracy, based on the number of the first temperature, the second temperature and the third temperature in which the predetermined change has occurred, whether the abnormality has occurred inside or outside the battery pack.

In a further embodiment, when the number of the first temperature, the second temperature and the third temperature in which the predetermined change has occurred exceeds the predetermined value, the control device identifies a location of the abnormality outside the battery pack using a position of the acquisition device in which the predetermined change has occurred among the first acquisition device, the second acquisition device and the third acquisition device.

Thus, it is possible to identify with high accuracy the location of the abnormality outside the battery pack.

In a further embodiment, the predetermined change includes a change greater than or equal to a predetermined value in a predetermined time period.

Thus, it is possible to determine with high accuracy whether the abnormality has occurred inside or outside the battery pack.

In a further embodiment, the abnormality determination system further includes a fourth acquisition device that acquires a fourth temperature indicating a temperature of a fourth region of the battery pack. The first region is a region on a right front side of the battery pack in a direction of travel of a vehicle. The second region is a region on a left front side of the battery pack in the direction of travel. The third region is a region on a right rear side of the battery pack in the direction of travel. The fourth region is a region on a left rear side of the battery pack in the direction of travel.

Thus, it is possible to identify with high accuracy the location of the abnormality outside or inside the battery pack.

In a further embodiment, the first acquisition device and the second acquisition device are mounted on a vehicle. The control device is provided in a server capable of communicating with the vehicle. When an abnormality occurs in the vehicle, the vehicle transmits information about the first temperature and the second temperature to the server.

Thus, it is possible for the server to determine with high accuracy whether the abnormality has occurred inside or outside the battery pack.

An abnormality determination system according to another aspect of the present disclosure determines whether an abnormality has occurred inside or outside a battery pack using a first temperature indicating a temperature of a first region of the battery pack, and a second temperature indicating a temperature of a second region different from the first region.

A vehicle according to another aspect of the present disclosure includes: a battery pack; a first acquisition device that acquires a first temperature indicating a temperature of a first region of the battery pack; a second acquisition device that acquires a second temperature indicating a temperature of a second region different from the first region; and a control device that transmits information about a history of the first temperature and a history of the second temperature to a server.

An abnormality determination method according to another aspect of the present disclosure is an abnormality determination method for determining an abnormality in a battery pack. The abnormality determination method includes: acquiring a first temperature indicating a temperature of a first region of the battery pack; acquiring a second temperature indicating a temperature of a second region different from the first region; and determining whether an abnormality has occurred inside or outside the battery pack using information about a history of the first temperature and a history of the second temperature.

A server according to another aspect of the present disclosure includes: an acquisition device that acquires, from a vehicle having a battery pack mounted thereon, information including a first temperature indicating a temperature of a first region of the battery pack, and a second temperature indicating a temperature of a second region different from the first region; and a control device that determines whether an abnormality has occurred inside the battery pack or outside the vehicle using the acquired first temperature and the acquired second temperature.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a diagram showing an example of a configuration of a battery system according to a first embodiment.
Fig. 2 shows an example of a configuration of a control device and a process executed by the control device.
Fig. 3 shows another example of a configuration of the control device and a process executed by the control device.
Fig. 4 shows yet another example of a configuration of the control device and a process executed by the control device.
Fig. 5 is a flowchart illustrating an example of a process of determining a cause.
Fig. 6 shows still yet another example of a configuration of the control device and a process executed by the control device.
Fig. 7 is a diagram showing an example of a configuration of an abnormality determination system according to a second embodiment.
Fig. 8 is a flowchart illustrating an example of a process executed by each of a vehicle and a server in the second embodiment.
Fig. 9 is a diagram showing an example of histories of results of detection by battery temperature sensors.
Fig. 10 is a diagram showing another example of histories of results of detection by the battery temperature sensors.
Fig. 11 is a diagram for illustrating operation of the abnormality determination system according to the second embodiment.

### DESCRIPTION OF THE PREFERRED EMBODIMENTS

Embodiments of the present disclosure will be hereinafter described in detail with reference to the drawings. In the drawings, the same or corresponding parts are denoted by the same reference characters, and description thereof will not be repeated.

### <First Embodiment>

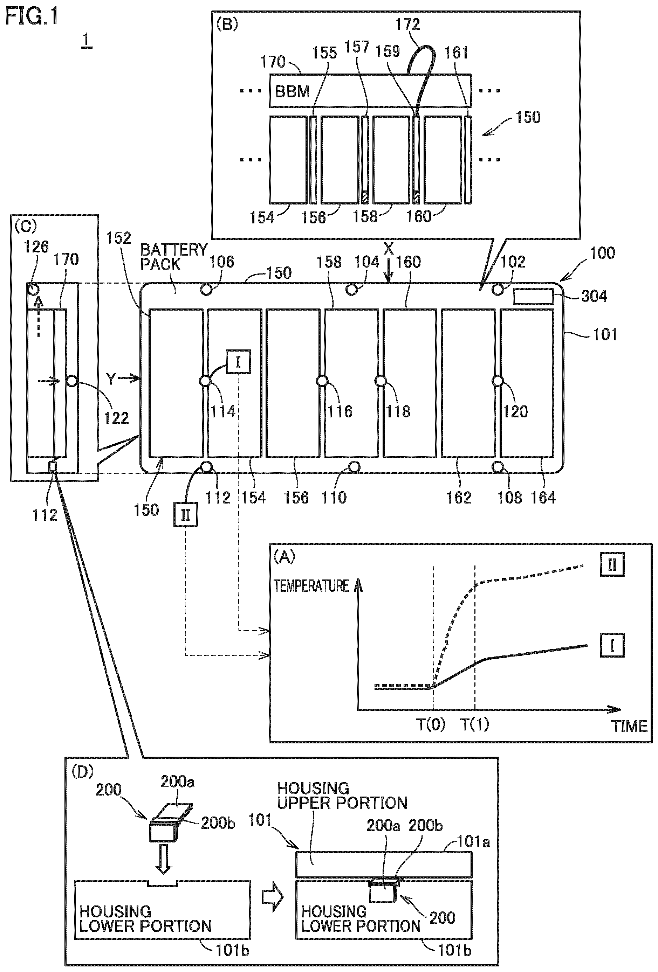

Fig. 1 is a diagram showing an example of a configuration of a battery system 1 according to a first embodiment. Battery system 1 includes a battery pack 100. Battery pack 100 is mounted, for example, on an electrically powered vehicle such as a battery electric vehicle or a hybrid electric vehicle. Battery pack 100 includes a housing 101, a battery stack 150, and a battery electronic control unit (ECU) 304. Battery stack 150 includes a plurality of battery cells 152, 154, 156, 158, 160, 162 and 164 (hereinafter referred to as a "plurality of battery cells 152 to 164"). Battery stack 150 is formed by arranging the plurality of battery cells, each of which has a larger area surface facing an adjacent battery cell. Battery stack 150 is housed in housing 101. Housing 101 is provided with a plurality of thermistors 102, 104, 106, 108, 110 and 112 (hereinafter referred to as "thermistors 102 to 112"). The plurality of thermistors 102 to 112 correspond to a "first detection device" that detects a temperature of housing 101. The plurality of thermistors 102 to 112 are each configured to be capable of detecting a temperature at a position where the thermistor is provided (hereinafter sometimes referred to as a "first temperature"). The positions where the plurality of thermistors 102 to 112 are provided are not particularly limited to those shown in Fig. 1, as long as the thermistors can detect the temperature of housing 101. The plurality of battery cells 152 to 164 are provided with a plurality of thermistors 114, 116, 118 and 120 (hereinafter referred to as "thermistors 114 to 120"). Specifically, thermistors 114 to 120 are provided between battery cells 152 and 154, between battery cells 156 and 158, between battery cells 158 and 160, and between battery cells 162 and 164, respectively. The plurality of thermistors 114 to 120 correspond to a "second detection device" that detects a temperature in housing 101. The plurality of thermistors 114 to 120 are each configured to be capable of detecting a temperature at a position where the thermistor is provided (hereinafter sometimes referred to as a "second temperature"). The positions where the plurality of thermistors 114 to 120 are provided are not particularly limited to those shown in Fig. 1, as long as the thermistors can detect the temperature in housing 101.

Each of thermistors 102 to 112 and thermistors 114 to 120 is a temperature sensor that detects temperature through changes in resistance value. The temperature sensor is not limited to a thermistor. Thermistors 102 to 112 and thermistors 114 to 120 are connected, for example, to battery ECU 304. Battery ECU 304 includes a central processing unit (CPU) and a memory that are not shown, and performs predetermined operation by executing a program and the like stored in the memory. Battery ECU 304 uses thermistors 102 to 112 and thermistors 114 to 120 to acquire information about the temperature at the position where each thermistor is provided.

For example, battery ECU 304 can determine, using results of detection by thermistors 102 to 112 and thermistors 114 to 120, a temperature abnormality in battery pack 100 when the temperature of battery pack 100 is within an abnormal temperature range (e.g., a high temperature range).

When an abnormal temperature increase is detected in battery pack 100, however, it is required to determine with high accuracy whether the abnormal temperature increase is due to a malfunction in any one of the battery cells of battery pack 100 or due to a change in an external environment of battery pack 100.

In the present embodiment, therefore, battery ECU 304 compares the results of detection by thermistors 102 to 112 with the results of detection by thermistors 114 to 120 to determine whether the temperature increase in battery pack 100 is due to a change in the external environment or due to a battery malfunction.

More specifically, when a first rate of increase in the first temperature detected by any one of thermistors 102 to 112 is higher than a second rate of increase in the second temperature detected by any one of thermistors 114 to 120, battery ECU 304 determines that the temperature increase is due to a change in the external environment, and when the second rate of increase is higher than the first rate of increase, battery ECU 304 determines that the temperature increase is due to a battery malfunction.

Thus, it is possible to use the results of detection by thermistors 102 to 112 and the results of detection by thermistors 114 to 120 to distinguish whether the temperature increase in battery pack 100 is due to a change in the external environment or due to a battery malfunction. It is thus possible to determine the cause of the abnormal temperature increase with high accuracy.

Battery ECU 304 calculates, for example, rates of increase in the temperatures detected by thermistors 102 to 112 and thermistors 114 to 120. Battery ECU 304 calculates, for example, an amount of change in temperature per unit time (hereinafter simply referred to as a "rate of increase"). When a predetermined condition is satisfied, battery ECU 304 compares a maximum value (1) of the rates of increase in the temperatures in thermistors 102 to 112 with a maximum value (2) of the rates of increase in the temperatures in thermistors 114 to 120. The predetermined condition may include, for example, a condition that at least one of thermistors 102 to 112 and thermistors 114 to 120, an average value, or a maximum value exceeds a threshold value, or a condition that a detection value of a cell temperature sensor (not shown) that detects the temperature of any one of the plurality of battery cells 152 to 164 exceeds a threshold value. The predetermined condition may be a condition for calculating the rate of increase.

For example, when the maximum value (1) is greater than the maximum value (2) and a magnitude of the difference between them is greater than a threshold value, battery ECU 304 determines that the temperature increase in battery pack 100 is due to a change in the external environment.

For example, when the maximum value (2) is greater than the maximum value (1) and a magnitude of the difference between them is greater than the threshold value, on the other hand, battery ECU 304 determines that the temperature increase in battery pack 100 is due to a battery malfunction.

Fig. 1 (A) shows an example of changes in the temperatures detected by thermistors 112 and 114. In Fig. 1 (A), the vertical axis represents temperature and the horizontal axis represents time. In Fig. 1 (A), a solid line (I) represents a temporal change in the temperature detected by thermistor 114, and a broken line (II) represents a temporal change in the temperature detected by thermistor 112.

Let us assume that the temperature of battery pack 100 rapidly increases between time T(0) and time T(1), followed by a gradual change in the rate of increase. At this time, battery ECU 304 calculates the rate of increase using the result of detection by each thermistor each time a result of detection is acquired. Battery ECU 304 calculates the rate of increase in each thermistor, and determines the maximum value (1) and the maximum value (2). In Fig. 1 (A), for example, a rate of increase calculated using the result of detection by thermistor 112 of thermistors 102 to 112 is determined as the maximum value (1), and a rate of increase calculated using the result of detection by thermistor 114 of thermistors 114 to 120 is determined as the maximum value (2). For example, when the maximum value (1) is greater than the maximum value (2) and a magnitude of the difference between the maximum value (1) and the maximum value (2) is greater than a threshold value in a time period from time T(0) to time T(1), battery ECU 304 determines that the temperature increase in the battery pack is due to a change in the external environment.

The present embodiment has described determining the cause of the temperature increase using the maximum value (1) and the maximum value (2), however, the cause of the temperature increase may be determined using a result of comparison (which is higher, and a magnitude of the difference) between an average value (1) of the rates of increase in the temperatures detected by thermistors 102 to 112 and an average value (2) of the rates of increase in the temperatures detected by thermistors 114 to 120. Further, when battery ECU 304 determines that the temperature increase is due to a battery malfunction, battery ECU 304 may identify a malfunctioning battery cell (e.g., a battery cell having a maximum temperature) using the results of detection by thermistors 114 to 120.

Thermistors 102 to 112 may be provided on insulating plates between the battery cells instead of at the positions shown in Fig. 1. FIG. 1 (B) shows an example of a cross-sectional view of battery pack 100 as seen in the direction of an arrow X. As shown in FIG. 1 (B), an insulating plate 155 is provided between battery cells 154 and 156. An insulating plate 157 is provided between battery cells 156 and 158. An insulating plate 159 is provided between battery cells 158 and 160. An insulating plate 161 is provided between battery cells 160 and 162.

A busbar module (hereinafter referred to as BBM) 170 is provided above battery stack 150. BBM 170 can connect the plurality of battery cells 152 to 164 in series by connecting the positive electrode terminals and the negative electrode terminals of the plurality of battery cells 152 to 164 in a predetermined combination.

In the present embodiment, the temperature sensor such as a thermistor that detects the temperature of housing 101 may be provided in a lower portion (hatched region) of the insulating plate. In this case, BBM 170 is provided with a circuit that connects the thermistor to battery ECU 304 in addition to a connection member that connects the terminals. In this way, each thermistor provided on the insulating plate is connected to BBM 170 through a harness 172, for example, thereby being able to transmit a temperature detection signal to battery ECU 304.

Further, thermistors 102 to 112 and thermistors 114 to 120 are provided at positions other than on a path along which gas generated from any one of battery cells 152 to 164 flows out of battery pack 100. Fig. 1 (C) shows a view of battery pack 100 as seen in the direction of an arrow Y. As shown in Fig. 1 (C), BBM 170 is provided above battery stack 150. For example, in the case where gas is generated from any one of the plurality of battery cells 152 to 164 in housing 101 of battery pack 100, when the gas flows out and is discharged out of battery pack 100 along a path indicated by a solid line arrow, the thermistors are positioned so as to be not disposed at a position 122 on the path. Alternatively, when the gas flows out and is discharged out of battery pack 100 along a path indicated by a broken line arrow, the thermistors are positioned so as to be not disposed at a position 126 on the path.

Further, thermistors 102 to 112 may be assembled and fixed so as to be sandwiched between an upper portion and a lower portion of housing 101. Fig. 1 (D) shows an example of fixing a heat collecting plate 200 to housing 101. Heat collecting plate 200 includes a plate-like member 200a and a seal member 200b. A thermistor that detects the temperature of housing 101 is attached to plate-like member 200a. A portion bent downward at a right angle is formed in the middle of plate-like member 200a. In a horizontal portion other than the portion bent at the right angle, seal member 200b is provided to surround plate-like member 200a in a width direction. Housing 101 includes an upper portion 101a and a lower portion 101b. Battery stack 150 is fixed to a bottom surface of lower portion 101b. Upper portion 101a is assembled to close an opening in lower portion 101b, to house battery stack 150 in housing 101. A recess is formed in a part of a surface of lower portion 101b that mates with upper portion 101a. The horizontal portion of plate-like member 200a is attached to the recess before upper portion 101a is assembled to lower portion 101b. When upper portion 101a is assembled to lower portion 101b, a gap of the recess is filled by plate-like member 200a and seal member 200b.

As described above, in battery system 1 according to the present embodiment, it is possible to use the results of detection by thermistors 102 to 112 that detect the temperature of housing 101 and the results of detection by thermistors 114 to 120 that detect the temperature in housing 101 to distinguish whether the temperature increase in battery pack 100 is due to a change in the external environment or due to a battery malfunction. More specifically, it is possible to determine that the temperature increase is due to a change in the external environment when the first rate of increase in the first temperature of any one of thermistors 102 to 112 is higher than the second rate of increase in the second temperature of any one of thermistors 114 to 120, and determine that the temperature increase is due to a battery malfunction when the second rate of increase is higher than the first rate of increase. Therefore, there can be provided a battery system capable of determining a cause of a temperature increase with high accuracy.

Further, since thermistors 102 to 112 are provided at positions other than on the path along which gas is discharged out of housing 101 from a battery cell upon generation of the gas in the battery cell, the effect of the gas generated in the battery cell on the detection of the first temperature and the second temperature is suppressed.

Further, since thermistors 102 to 112 are provided in the lower portions of the insulating plates between the battery cells, thermistors 102 to 112 can be readily assembled to the battery stack.

Modifications are described below.

The above embodiment has described an example in which battery ECU 304 determines the cause of the temperature increase in battery pack 100, however, the results of detection by the thermistors or the result of determination of the cause of the temperature increase may be transmitted to another control device (such as another ECU or an external server).

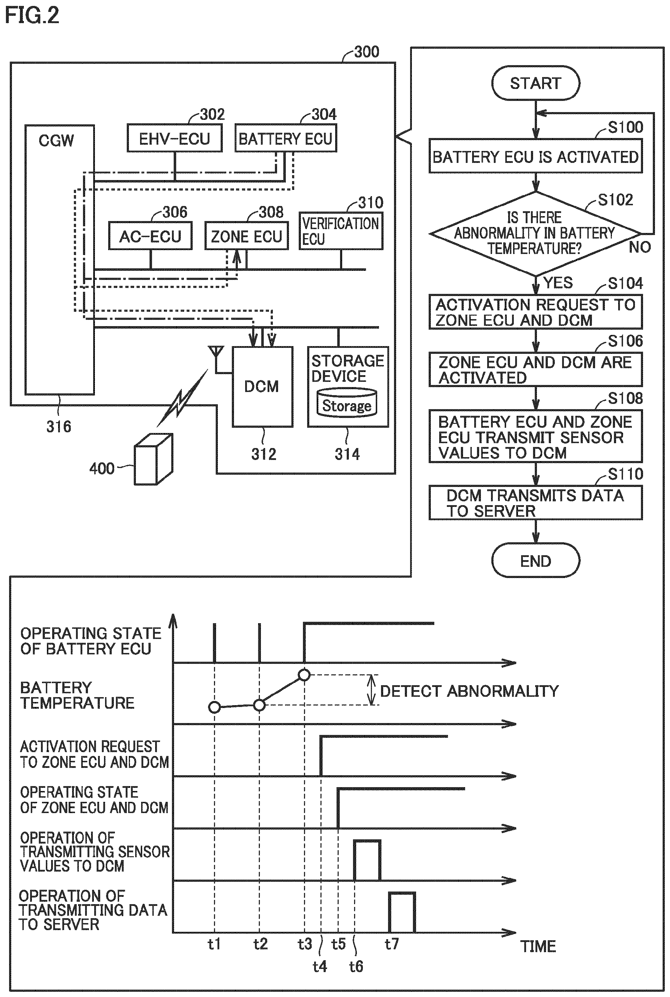

Fig. 2 is a diagram showing an example of a configuration, process, and operation of a control device 300 in a modification. As shown in Fig. 2, control device 300 further includes, in addition to battery ECU 304, an EHV-ECU 302, an AC-ECU 306, a zone ECU 308, a verification ECU 310, a data communication module (DCM) 312, a storage device 314, and a central gateway (hereinafter referred to as CGW) 316. EHV-ECU 302 comprehensively controls a vehicle system in coordination with the other ECUs. AC-ECU 306 controls an air conditioner. Zone ECU 308 controls operation of a device in a region set in advance in the vehicle (such as the front, center, or rear of the vehicle). Verification ECU 310 executes a verification process such as for locking and unlocking. DCM 312 is configured to be capable of communicating with an external server 400. Storage device 314 stores various types of information in a storage area (storage). CGW 316 relays communication between, for example, a communication network including EHV-ECU 302 and battery ECU 304, a communication network including AC-ECU 306, zone ECU 308 and verification ECU 310, and a communication network including DCM 312 and storage device 314.

Each ECU includes a processor and a memory (neither shown). When the processor executes a program stored in the memory, prescribed operation in a control target is implemented. When control device 300 executes the process shown in a flowchart of Fig. 2, the operation shown in a timing chart of Fig. 2 is performed.

In step (step is hereinafter referred to as S) 100, battery ECU 304 is activated. Battery ECU 304 is activated when, for example, a prescribed activation condition is satisfied while the vehicle system is in a stop state. The prescribed activation condition includes a condition that a predetermined amount of time has elapsed since a time point of previous activation. In S102, battery ECU 304 determines whether or not there is an abnormality in the battery temperature. When a magnitude of the difference between a current value and a previous value of the temperature detected by the cell temperature sensor is greater than a threshold value, battery ECU 304 determines that there is an abnormality in the battery temperature. When it is determined that there is an abnormality in the battery temperature (YES in S102), the process moves to S104. When it is determined that there is no abnormality in the battery temperature (NO in S102), the process returns to S100. In S104, battery ECU 304 transmits an activation request to zone ECU 308 and DCM 312. In S106, zone ECU 308 and DCM 312 are activated in response to the activation request. In S108, battery ECU 304 and zone ECU 308 output various sensor values, which include sensor output values of thermistors 102 to 112 and thermistors 114 to 120 (hereinafter simply referred to as sensor values), to DCM 312. The various sensor values further include a temperature of each battery cell, a voltage of each battery cell (hereinafter referred to as a cell voltage), and an outside air temperature. The cell voltage is detected by a voltage sensor (not shown) provided in each of battery cells 152 to 164, and transmitted to control device 300. In the following description, the sensor values detected by thermistors 114 to 120 may be referred to as a pack atmosphere temperature, and the sensor value of the cell temperature sensor may be referred to as a cell temperature. In S110, DCM 312 transmits the received sensor values to server 400.

When such a process is executed, the magnitude of the temperature difference becomes smaller than or equal to the threshold value and battery ECU 304 is intermittently activated at time t1 and time t2, as shown in the timing chart of Fig. 2. When the magnitude of the temperature difference becomes greater than the threshold value at time t3, it is determined that there is an abnormality in the battery temperature (YES in S102). In this case, an activation request is transmitted to zone ECU 308 and DCM 312 at time t4 (S104), and zone ECU 308 and DCM 312 are activated at time t5 (S106). At time t6, battery ECU 304 and zone ECU 308 transmit sensor values to DCM 312 (S108). At time t7, DCM 312 transmits the received sensor values to server 400 (S110). Server 400 executes a prescribed analysis process using the received data. The prescribed analysis process includes, for example, a process of determining whether the temperature increase in battery pack 100 is due to a battery malfunction or due to a change in the external environment. Since the determination method is as described above, detailed description will not be repeated. Thus, server 400 can make the determination on the abnormal temperature increase in battery pack 100. An example in which server 400 determines the cause of the temperature increase has been described, however, for example, the result of determination of the cause of the temperature increase by battery ECU 304 may be transmitted, instead of or in addition to the sensor values, to server 400 via DCM 312. DCM 312 transmits, together with the received data, identification information (such as a production number) for identifying the vehicle or battery pack 100 to the server. Server 400 stores the identification information and the received data in a storage device in association with each other.

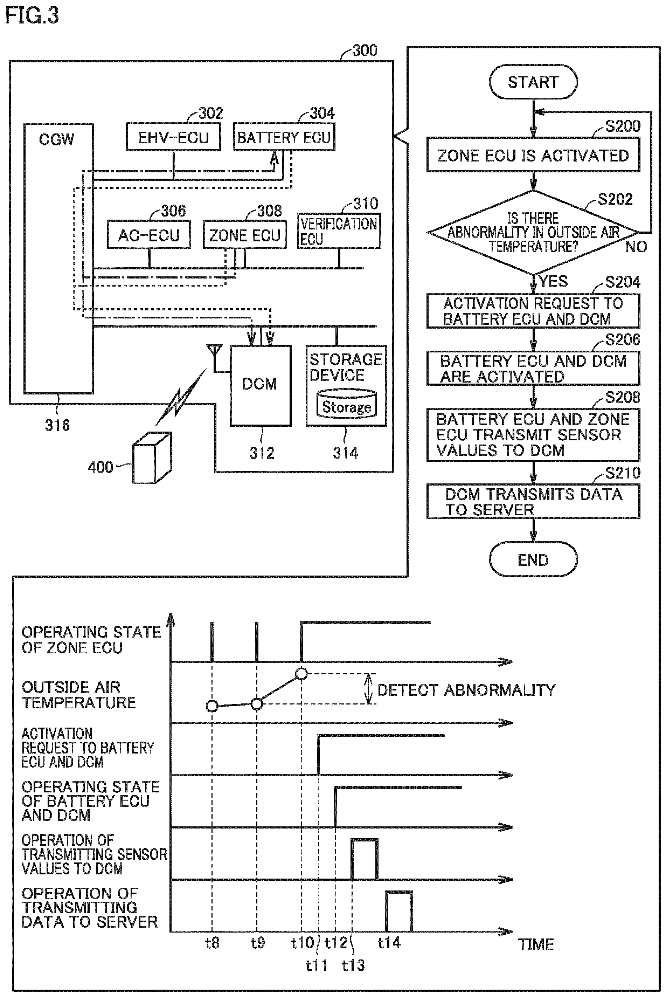

Fig. 3 is a diagram showing another example of a configuration, process, and operation of control device 300 in a modification. Control device 300 in Fig. 3 is similar to control device 300 in Fig. 2 except for operation described below, and detailed description will not be repeated. When control device 300 executes the process shown in a flowchart of Fig. 3, the operation shown in a timing chart of Fig. 3 is performed.

In S200, zone ECU 308 is activated. Zone ECU 308 is activated when a prescribed activation condition (the same condition as described above) is satisfied while the vehicle system is in a stop state. In S202, zone ECU 308 determines whether or not there is an abnormality in the outside air temperature. When a magnitude of the difference between a current value and a previous value of the outside air temperature detected by an outside air temperature sensor that is not shown is greater than a threshold value, zone ECU 308 determines that there is an abnormality in the outside air temperature. When it is determined that there is an abnormality in the outside air temperature (YES in S202), the process moves to S204. When it is determined that there is no abnormality in the outside air temperature (NO in S202), the process returns to S200. In S204, zone ECU 308 transmits an activation request to battery ECU 304 and DCM 312. In S206, battery ECU 304 and DCM 312 are activated in response to the activation request. In S208, battery ECU 304 and zone ECU 308 output various sensor values to DCM 312. In S210, DCM 312 transmits the received sensor values to server 400.

When such a process is executed, the magnitude of the difference between the current value and the previous value of the outside air temperature becomes smaller than or equal to the threshold value and zone ECU 308 is intermittently activated at time t8 and time t9, as shown in the timing chart of Fig. 3. When the magnitude of the difference becomes greater than the threshold value at time t10, it is determined that there is an abnormality in the outside air temperature (YES in S202). An activation request is transmitted to battery ECU 304 and DCM 312 at time t11 (S204), and battery ECU 304 and DCM 312 are activated at time t12 (S206). At time t13, battery ECU 304 and zone ECU 308 transmit sensor values to DCM 312 (S208). At time t14, DCM 312 transmits the received sensor values to server 400 (S210). Since the operation of server 400 is as described above, detailed description will not be repeated.

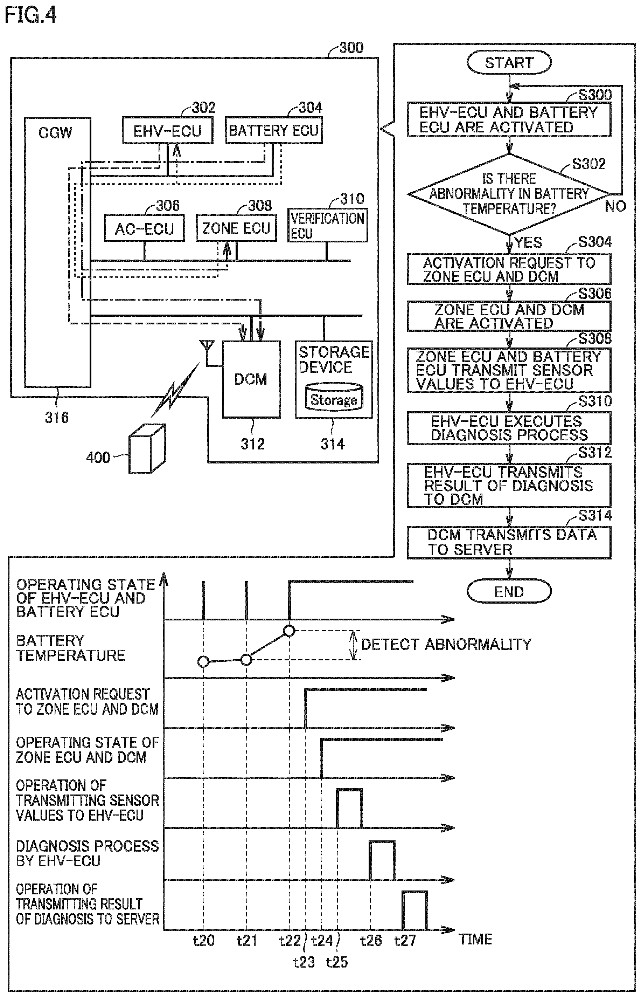

Fig. 4 is a diagram showing yet another example of a configuration, process, and operation of control device 300 in a modification. Control device 300 in Fig. 4 is similar to control device 300 in Fig. 2 except for operation described below, and detailed description will not be repeated. When control device 300 executes the process shown in a flowchart of Fig. 4, the operation shown in a timing chart of Fig. 4 is performed.

In S300, EHV-ECU 302 and battery ECU 304 are activated. EHV-ECU 302 and battery ECU 304 are activated when a prescribed activation condition (the same condition as described above) is satisfied while the vehicle system is in a stop state. In S302, EHV-ECU 302 or battery ECU 304 determines whether or not there is an abnormality in the battery temperature. The determination method is as described above, and detailed description will not be repeated. When it is determined that there is an abnormality in the battery temperature (YES in S302), the process moves to S304. When it is determined that there is no abnormality in the battery temperature (NO in S302), the process returns to S300. In S304, EHV-ECU 302 or battery ECU 304 transmits an activation request to zone ECU 308 and DCM 312. In S306, zone ECU 308 and DCM 312 are activated in response to the activation request. In S308, zone ECU 308 and battery ECU 304 transmit sensor values to EHV-ECU 302. In S310, EHV-ECU 302 executes a diagnosis process. The diagnosis process will be described later. In S312, EHV-ECU 302 transmits a result of diagnosis to DCM 312. In S314, DCM 312 transmits data on the result of diagnosis to server 400.

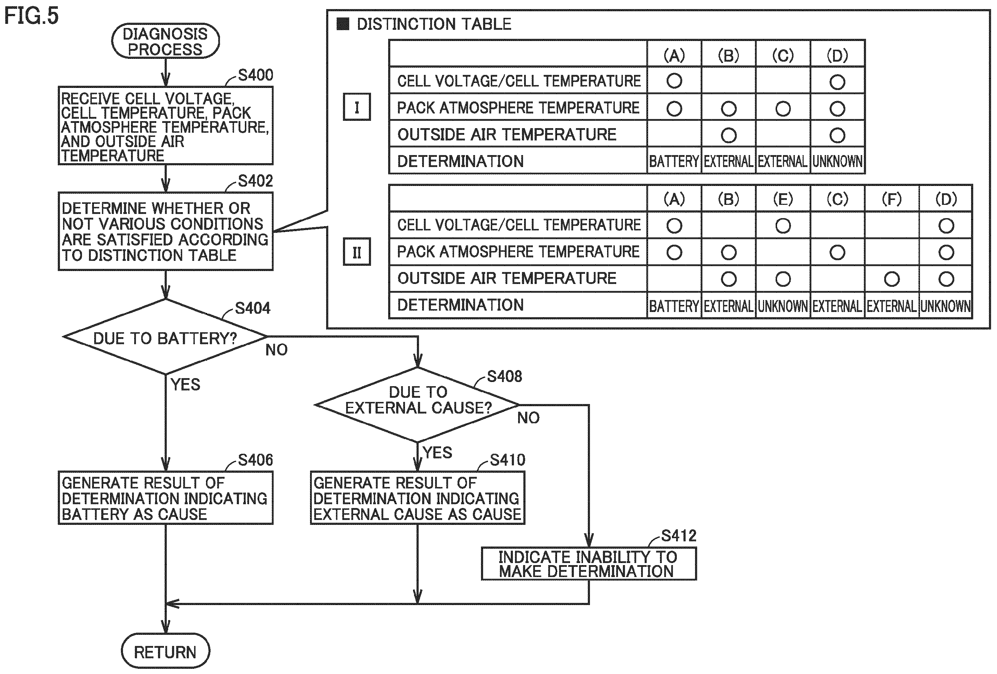

Fig. 5 is a flowchart illustrating an example of the diagnosis process. EHV-ECU 302 executes the process shown in Fig. 5 as the diagnosis process.

In S400, EHV-ECU 302 receives a cell voltage, a cell temperature, a pack atmosphere temperature, and an outside air temperature. EHV-ECU 302 receives the above information from zone ECU 308 and battery ECU 304. In S402, EHV-ECU 302 determines whether or not various conditions are satisfied in order to distinguish, according to a distinction table, whether a temperature abnormality in battery pack 100 is due to a battery malfunction, due to a change in the external environment, or due to an unknown cause. Based on a combination of satisfied conditions, EHV-ECU 302 determines whether the temperature abnormality is due to a battery malfunction, due to a change in the external environment, or due to an unknown cause. In the process shown in Fig. 4, the cause of the temperature abnormality is determined according to a distinction table (I) in Fig. 5.

The distinction table (I) in Fig. 5 shows: whether or not a condition 1 for the cell voltage/cell temperature is satisfied; whether or not a condition 2 for the pack atmosphere temperature is satisfied; whether or not a condition 3 for the outside air temperature is satisfied; and results of determination (A) to (D) obtained from combinations of these conditions. Condition 1 includes a condition that the cell voltage or the cell temperature (the temperature detected by the cell temperature sensor) of at least one of the plurality of battery cells is greater than a threshold value. Condition 2 includes a condition that the pack atmosphere temperature (the temperature detected by at least one of thermistors 114 to 120) is greater than a threshold value. Condition 3 includes a condition that the outside air temperature is greater than a threshold value.

When condition 1 and condition 2 of the above conditions are satisfied, the result of determination (A) indicating a battery malfunction as the cause is set. When condition 2 and condition 3 are satisfied, the result of determination (B) indicating a change in the external environment as the cause is set. When only condition 2 is satisfied, the result of determination (C) indicating a change in the external environment as the cause is set. When all of condition 1, condition 2 and condition 3 are satisfied, the result of determination (D) indicating an unknown cause is set.

In S404, EHV-ECU 302 determines whether the temperature increase in battery pack 100 is due to a battery malfunction. When it is determined that the temperature increase is due to a battery malfunction (YES in S404), the process moves to S406. In S406, EHV-ECU 302 generates a result of determination indicating a battery malfunction as the cause. When it is determined that the temperature increase is not due to a battery malfunction (NO in S404), the process moves to S408. In S408, EHV-ECU 302 determines whether the temperature increase is due to a change in the external environment. When it is determined that the temperature increase is due to a change in the external environment (YES in S408), the process moves to S410. In S410, EHV-ECU 302 generates a result of determination indicating a change in the external environment as the cause. When it is determined that the temperature increase is not due to a change in the external environment (NO in S408), the process moves to S412. In S412, EHV-ECU 302 generates a result of determination indicating inability to make a determination. The generated result of determination is transmitted to DCM 312 in S312.

When such a process is executed, the magnitude of the temperature difference in battery temperature becomes smaller than or equal to the threshold value and EHV-ECU 302 and battery ECU 304 are intermittently activated at times t20 and t21, as shown in the timing chart of Fig. 4. When the magnitude of the temperature difference becomes greater than the threshold value at time t22, it is determined that there is an abnormality in the battery temperature (YES in S302). An activation request is transmitted to zone ECU 308 and DCM 312 at time t23 (S304), and zone ECU 308 and DCM 312 are activated at time t24 (S306). At time t25, zone ECU 308 and battery ECU 304 transmit sensor values to EHV-ECU 302 (S308). At time t26, EHV-ECU 302 executes a diagnosis process (S310). When the diagnosis process is executed, the received cell voltage, cell temperature, pack atmosphere temperature and outside air temperature are used (S400) to determine whether or not the various conditions are satisfied (S402). When the result of determination (A) is obtained according to the distinction table (I) (YES in S404), a result of determination indicating a battery malfunction as the cause is generated (S406). On the other hand, when the result of determination (B) or (C) is obtained (NO in S404 and YES in S406), a result of determination indicating a change in the external environment as the cause is generated (S410). At time t27, EHV-ECU 302 transmits a result of determination (a result of diagnosis) of the diagnosis process to DCM 312 (S312). DCM 312 transmits the received result of diagnosis to server 400 (S314).

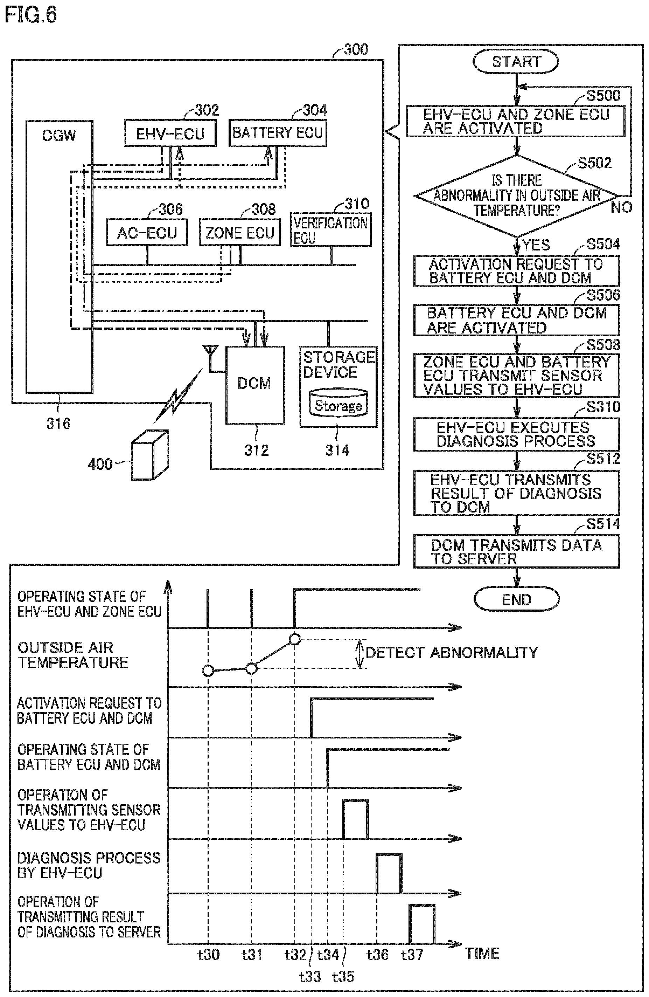

Fig. 6 is a diagram showing still yet another example of a configuration, process, and operation of control device 300 in a modification. Control device 300 in Fig. 6 is similar to control device 300 in Fig. 2 except for operation described below, and detailed description will not be repeated. When control device 300 executes the process shown in a flowchart of Fig. 6, the operation shown in a timing chart of Fig. 6 is performed.

In S500, EHV-ECU 302 and zone ECU 308 are activated. EHV-ECU 302 and zone ECU 308 are activated when a prescribed activation condition (the same condition as described above) is satisfied while the vehicle system is in a stop state. In S502, EHV-ECU 302 or zone ECU 308 determines whether or not there is an abnormality in the outside air temperature. The determination method is as described above, and detailed description will not be repeated. When it is determined that there is an abnormality in the outside air temperature (YES in S502), the process moves to S504. When it is determined that there is no abnormality in the outside air temperature (NO in S502), the process returns to S500. In S504, EHV-ECU 302 or zone ECU 308 transmits an activation request to battery ECU 304 and DCM 312. In S506, battery ECU 304 and DCM 312 are activated. In S508, battery ECU 304 and zone ECU 308 transmit sensor values to EHV-ECU 302. In S510, EHV-ECU 302 executes a diagnosis process. This diagnosis process is different from the process described in Fig. 5 in that a result of determination indicating the cause of the temperature abnormality is generated according to a distinction table (II) instead of the distinction table (I) in Fig. 5. The process is otherwise as described above, and detailed description will not be repeated.

The distinction table (II) in Fig. 5 shows: whether or not condition 1 is satisfied; whether or not condition 2 is satisfied; whether or not condition 3 is satisfied; and results of determination (A) to (F) obtained from combinations of these conditions. Details of conditions 1 to 3, as well as details of and satisfied conditions for the results of determination (A) to (D) are as described above, and detailed description will not be repeated. When condition 1 and condition 3 are satisfied, a result of determination (E) indicating an unknown cause is set. When only condition 3 is satisfied, a result of determination (F) indicating a change in the external environment as the cause is set.

In S512, EHV-ECU 302 transmits a result of diagnosis to DCM 312. In S514, DCM 312 transmits data on the result of diagnosis to server 400.

When such a process is executed, the magnitude of the difference between the current value and the previous value of the outside air temperature becomes smaller than or equal to the threshold value and EHV-ECU 302 and zone ECU 308 are intermittently activated at times t30 and t31, as shown in the timing chart of Fig. 6. When the magnitude of the difference becomes greater than the threshold value at time t32, it is determined that there is an abnormality in the outside air temperature (YES in S502). In this case, an activation request is transmitted to battery ECU 304 and DCM 312 at time t33 (S504), and battery ECU 304 and DCM 312 are activated at time t34 (S506). At time t35, zone ECU 308 and battery ECU 304 transmit sensor values to EHV-ECU 302 (S508). At time t36, EHV-ECU 302 executes a diagnosis process (S510). When the diagnosis process is executed, the received cell voltage, cell temperature, pack atmosphere temperature and outside air temperature are used (S400) to determine whether or not the various conditions are satisfied (S402). When the result of determination (A) is obtained according to the distinction table (II) (YES in S404), a result of determination indicating a battery malfunction as the cause is generated (S406). On the other hand, when the result of determination (B), (C) or (F) is obtained (NO in S404 and YES in S406), a result of determination indicating a change in the external environment as the cause is generated (S410). At time t37, EHV-ECU 302 transmits a result of determination (a result of diagnosis) of the diagnosis process to DCM 312 (S512). DCM 312 transmits the received result of diagnosis to server 400 (S514).

The modifications described above may be implemented in the form of being wholly or partially combined as appropriate.

### <Second Embodiment>

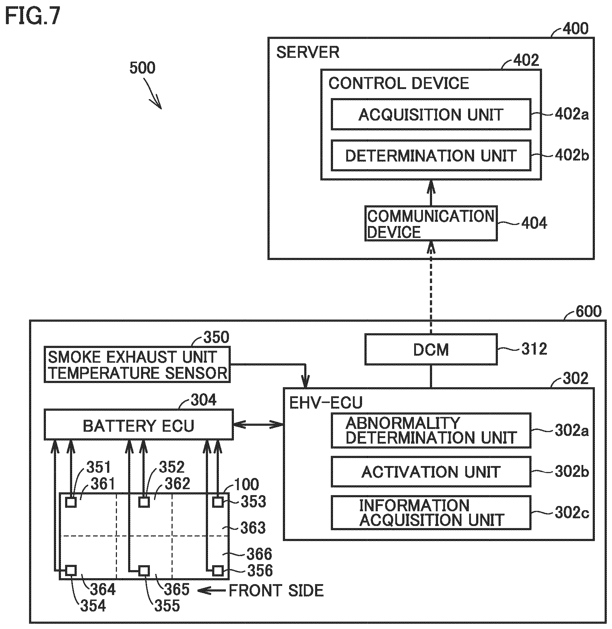

A configuration and operation of an abnormality determination system according to a second embodiment are described below. The abnormality determination system according to the present embodiment is configured, when the temperature of a battery pack mounted on a vehicle increases, to determine whether the temperature increase is due to an abnormality inside the battery pack or due to an abnormality (e.g., fire) outside the battery pack using a plurality of battery temperature sensors provided in the battery pack. The configuration of the abnormality determination system according to the present embodiment is described below with reference to Fig. 7.

Fig. 7 is a diagram showing an example of a configuration of an abnormality determination system 500 according to the second embodiment. As shown in Fig. 7, abnormality determination system 500 includes a server 400 and a vehicle 600. Server 400 is communicably connected to each of a plurality of vehicles including vehicle 600. Identification information for identifying the plurality of vehicles is stored in advance, for example, in a storage device (not shown) of server 400, and identification information received from the plurality of vehicles is used to identify a communication target vehicle. Although Fig. 7 shows an example in which server 400 and vehicle 600 are communicably connected to each other, server 400 is also similarly communicably connected to the other vehicles, and detailed description thereof will not be repeated.

Server 400 includes a control device 402 and a communication device 404. Control device 402 includes an acquisition unit 402a and a determination unit 402b.

Acquisition unit 402a acquires, from vehicle 600, information about histories of results of detection by (histories of output values of) a plurality of battery temperature sensors described later. Determination unit 402b identifies a location of an abnormality using the information acquired by acquisition unit 402a. A method for identifying the location of the abnormality will be described later.

Communication device 404 is configured to be capable of wirelessly communicating with a DCM 312 of vehicle 600. Since the method of communication between server 400 and DCM 312 is as described above in the first embodiment, detailed description thereof will not be repeated.

Vehicle 600 includes an EHV-ECU 302, a battery ECU 304, DCM 312, a smoke exhaust unit temperature sensor 350, a first battery temperature sensor 351, a second battery temperature sensor 352, a third battery temperature sensor 353, a fourth battery temperature sensor 354, a fifth battery temperature sensor 355, and a sixth battery temperature sensor 356. In the following description, first battery temperature sensor 351, second battery temperature sensor 352, third battery temperature sensor 353, fourth battery temperature sensor 354, fifth battery temperature sensor 355, and sixth battery temperature sensor 356 may be collectively referred to as "battery temperature sensors." EHV-ECU 302, battery ECU 304, and DCM 312 are configured in a similar manner to EHV-ECU 302, battery ECU 304, and DCM 312 described above in the first embodiment. Thus, detailed description thereof will not be repeated.

Smoke exhaust unit temperature sensor 350 is provided in a smoke exhaust unit of a battery pack 100, and detects a temperature of gas in the smoke exhaust unit and transmits a signal indicating a result of detection to EHV-ECU 302. The smoke exhaust unit is configured to direct gas out of battery pack 100 when the gas or the like is emitted from at least one of a plurality of battery cells in battery pack 100. Smoke exhaust unit temperature sensor 350 transmits a signal indicating a result of detection to EHV-ECU 302 upon each lapse of a predetermined amount of time, even while a system of vehicle 600 is in a stop state.

Fig. 7 shows battery pack 100 as seen from above, where the left side as seen on the drawing refers to the front side of vehicle 600. Battery pack 100 is formed by arranging a predetermined number of plurality of cells that are not shown. The outline of battery pack 100 as seen from above has a rectangular shape, and the rectangular region is divided into six parts to set a plurality or regions, with each region being provided with a corresponding battery temperature sensor. Specifically, as shown in Fig. 7, the rectangular region of battery pack 100 as seen from above includes: a first region 361 set on the right front side of battery pack 100; a second region 362 set on the right center side of battery pack 100; a third region 363 set on the right rear side of battery pack 100; a fourth region 364 set on the left front side of battery pack 100; a fifth region 365 set on the left center side of battery pack 100; and a sixth region 366 set on the left rear side of battery pack 100.

First battery temperature sensor 351 is provided in first region 361, and detects the temperature of any one of the battery cells in first region 361 and transmits a result of detection to battery ECU 304. Second battery temperature sensor 352 is provided in second region 362, and detects the temperature of any one of the battery cells in second region 362 and transmits a result of detection to battery ECU 304. Third battery temperature sensor 353 is provided in third region 363, and detects the temperature of any one of the battery cells in third region 363 and transmits a result of detection to battery ECU 304. Fourth battery temperature sensor 354 is provided in fourth region 364, and detects the temperature of any one of the battery cells in fourth region 364 and transmits a result of detection to battery ECU 304. Fifth battery temperature sensor 355 is provided in fifth region 365, and detects the temperature of any one of the battery cells in fifth region 365 and transmits a result of detection to battery ECU 304. Sixth battery temperature sensor 356 is provided in sixth region 366, and detects the temperature of any one of the battery cells in sixth region 366 and transmits a result of detection to battery ECU 304.

The battery temperature sensors may each transmit a result of detection to an ECU other than battery ECU 304, and the ECU other than battery ECU 304 may transmit the result of detection to battery ECU 304, or an ECU other than battery ECU 304 and EHV-ECU 302 may transmit the result of detection to EHV-ECU 302.

EHV-ECU 302 includes an abnormality detection unit 302a, an activation unit 302b, and an information acquisition unit 302c.

Abnormality detection unit 302a determines whether or not an abnormality has occurred in vehicle 600 while the system of vehicle 600 is in a stop state. For example, when the temperature detected by smoke exhaust unit temperature sensor 350 has increased above a threshold value in an immediately preceding predetermined time period in vehicle 600 while the system is in a stop state, abnormality detection unit 302a determines that an abnormality has occurred in vehicle 600 while the system is in a stop state. When abnormality detection unit 302a determines that an abnormality has occurred, abnormality detection unit 302a may set an abnormality occurrence flag to an ON state, for example.

When abnormality detection unit 302a determines that an abnormality has occurred, activation unit 302b activates predetermined electrical devices. The predetermined electrical devices include devices for determining whether the abnormality has occurred inside or outside battery pack 100. The predetermined electrical devices include, for example, DCM 312 and the battery temperature sensors. Activation unit 302b activates the predetermined electrical devices when, for example, the abnormality occurrence flag is in an ON state.

Information acquisition unit 302c acquires information about histories of results of detection by the battery temperature sensors. Information acquisition unit 302c acquires, for example, histories of output values of the battery temperature sensors in the most recent predetermined time period from a time point when the abnormality was determined to have occurred. Information acquisition unit 302c continuously acquires histories of output values of the battery temperature sensors after the time point when the abnormality was determined to have occurred. Information acquisition unit 302c transmits information about the acquired various histories to server 400 via DCM 312. The information about the various histories may include, for example, histories of output voltage values or histories of values converted into a temperature representation.

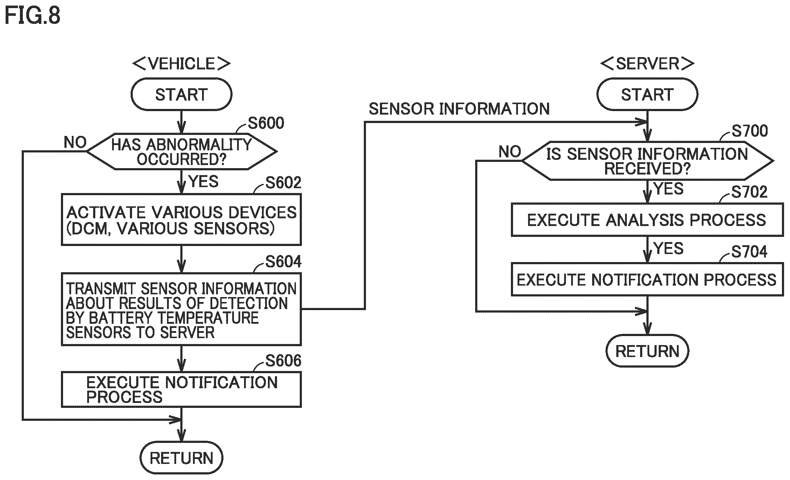

An example of operation of abnormality determination system 500 according to the present embodiment is described below with reference to Fig. 8. Fig. 8 is a flowchart illustrating an example of a process executed by each of vehicle 600 and server 400 in the second embodiment. The process shown in Fig. 8 is repeatedly executed at prescribed control intervals by each of vehicle 600 (specifically, a control device 300) and server 400 (specifically, control device 402). Details of the process executed by control device 300 of vehicle 600 are described below.

In S600, control device 300 determines whether or not an abnormality has occurred. Since the determination method is as described above, detailed description thereof will not be repeated. When it is determined that an abnormality has occurred (YES in S600), the process moves to S602.

In S602, control device 300 activates various devices (specifically, the predetermined electrical devices including DCM 312 and the battery temperature sensors). Control device 300 activates the various devices by suppling electric power to DCM 312 and suppling electric power to ECUs connected to the battery temperature sensors, thereby enabling acquisition of sensor information and transmission to server 400. The process then moves to S604.

In S604, control device 300 acquires information about histories of results of detection by the battery temperature sensors (hereinafter referred to as sensor information), and transmits the acquired sensor information to server 400. The process then moves to S606.

In S606, control device 300 executes a notification process. In the notification process, for example, character information or an image indicating the occurrence of the abnormality may be displayed on a display device (not shown) in vehicle 600. When it is determined that no abnormality has occurred (NO in S600), the process ends. Next, details of the process executed by control device 402 of server 400 are described.

In S700, control device 402 determines whether or not the sensor information is received from vehicle 600. When it is determined that the sensor information is received (YES in S700), the process moves to S702.

In S702, control device 402 executes an analysis process of analyzing the sensor information. For example, control device 402 determines whether the abnormality has occurred inside battery pack 100 or outside vehicle 600 using the sensor information.

For example, when a predetermined change occurs in fewer than a predetermined number of detection targets in the output values of the battery temperature sensors, control device 402 determines that the abnormality has occurred inside battery pack 100. For example, when the predetermined change occurs in greater than or equal to the predetermined number of detection targets in the output values of the battery temperature sensors, control device 402 determines that the abnormality has occurred outside vehicle 600. The present embodiment describes an example in which the predetermined number is two, however, the number is not particularly limited to two. The predetermined change includes, for example, a change in which the amount of change per unit time exceeds a threshold value. The threshold value is set in advance for each sensor, for example.

Further, when it is determined that the abnormality is inside battery pack 100, control device 402 identifies a location of the abnormality inside battery pack 100 according to the position of a sensor in which the predetermined change has occurred. For example, when the predetermined change occurs in the sensor in first region 361, control device 402 determines that the abnormality has occurred in first region 361 of battery pack 100. In this way, control device 402 identifies the region provided with the sensor in which the predetermined change has occurred as the location of the abnormality.

Further, when it is determined that the abnormality is outside battery pack 100, control device 402 identifies a location of the abnormality outside vehicle 600 according to the position of a sensor in which the predetermined change has occurred. For example, when the predetermined change occurs in the sensors provided in first region 361 and fourth region 364 of the battery temperature sensors, control device 402 determines that the abnormality has occurred on the front side of vehicle 600. Further, when the predetermined change occurs in the sensors provided in third region 363 and sixth region 366 of the battery temperature sensors, control device 402 determines that the abnormality has occurred on the rear side of vehicle 600. Further, when the predetermined change occurs in the sensors provided in first region 361 and second region 362 of the battery temperature sensors, control device 402 determines that the abnormality has occurred on the right front side of vehicle 600. In this way, control device 402 identifies the outside of vehicle 600 on the side of the region provided with the sensor in which the predetermined change has occurred as the location of the abnormality.

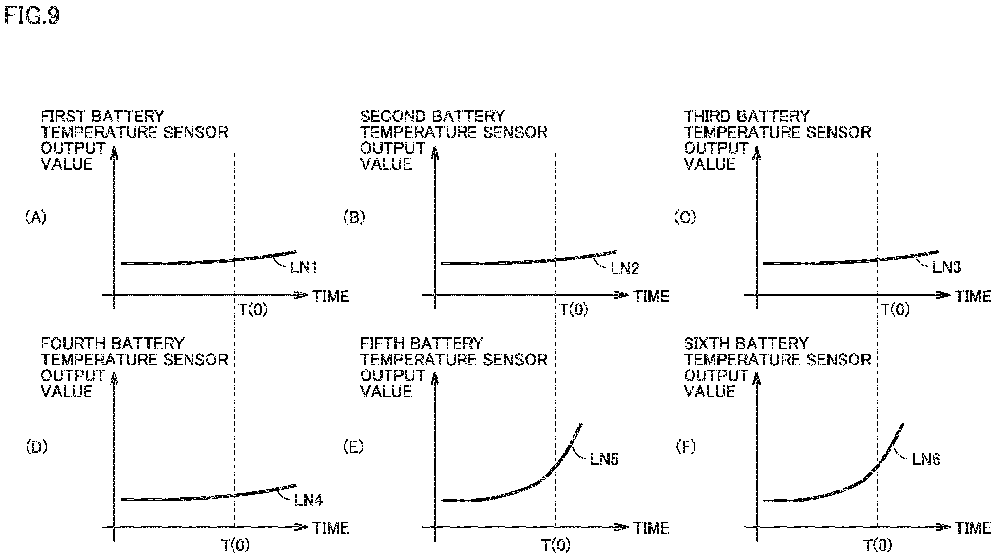

Fig. 9 is a diagram showing an example of histories of results of detection by the battery temperature sensors. The vertical axes in Figs. 9 (A) to (F) represent output values of first battery temperature sensor 351 to sixth battery temperature sensor 356, respectively. Each horizontal axis in Figs. 9 (A) to (F) represents time.

Fig. 9 (A) shows a relationship between the output value of first battery temperature sensor 351 and time, where LN1 in Fig. 9 indicates an example of a temporal change in the output value of first battery temperature sensor 351. Fig. 9 (B) shows a relationship between the output value of second battery temperature sensor 352 and time, where LN2 in Fig. 9 indicates an example of a temporal change in the output value of second battery temperature sensor 352. Fig. 9 (C) shows a relationship between the output value of third battery temperature sensor 353 and time, where LN3 in Fig. 9 indicates an example of a temporal change in the output value of third battery temperature sensor 353. Fig. 9 (D) shows a relationship between the output value of fourth battery temperature sensor 354 and time, where LN4 in Fig. 9 indicates an example of a temporal change in the output value of fourth battery temperature sensor 354. Fig. 9 (E) shows a relationship between the output value of fifth battery temperature sensor 355 and time, where LN5 in Fig. 9 indicates an example of a temporal change in the output value of fifth battery temperature sensor 355. Fig. 9 (F) shows a relationship between the output value of sixth battery temperature sensor 356 and time, where LN6 in Fig. 9 indicates an example of a temporal change in the output value of sixth battery temperature sensor 356.

Control device 402 calculates, for example: a first amount of change per unit time in the output value of first battery temperature sensor 351; a second amount of change per unit time in the output value of second battery temperature sensor 352; a third amount of change per unit time in the output value of third battery temperature sensor 353; a fourth amount of change per unit time in the output value of fourth battery temperature sensor 354; a fifth amount of change per unit time in the output value of fifth battery temperature sensor 355; and a sixth amount of change per unit time in the output value of sixth battery temperature sensor 356.

For example, when each of the fifth amount of change and the sixth amount of change exceeds a threshold value and none of the first amount of change to the fourth amount of change exceeds the threshold value at time T(0) as indicated by LN1 to LN6 in Fig. 9, control device 402 determines that the abnormality has occurred outside vehicle 600 because the predetermined change has occurred in two or more detection targets. At this time, control device 402 determines that the abnormality has occurred on the left rear side of vehicle 600.

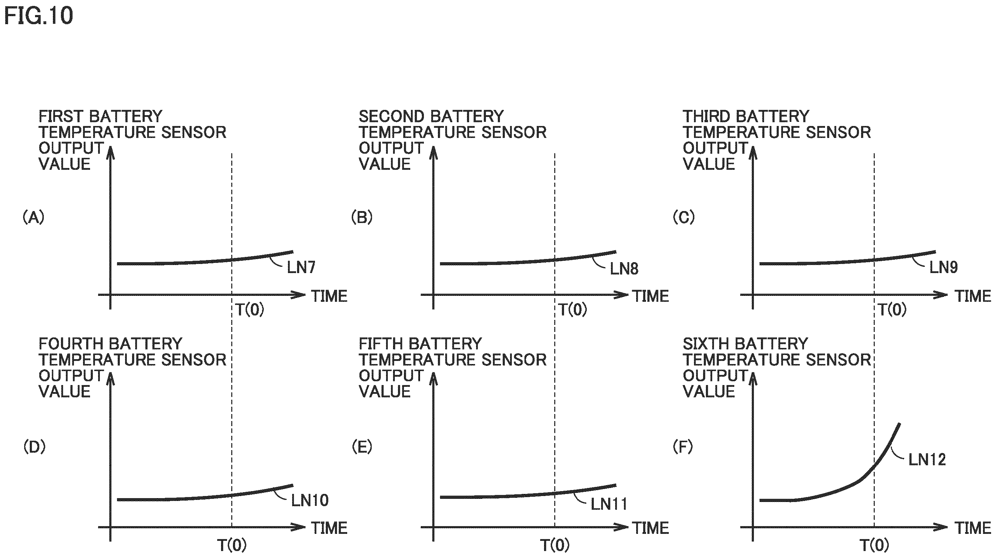

Fig. 10 is a diagram showing another example of histories of results of detection by the battery temperature sensors. The vertical axes in Figs. 10 (A) to (F) represent output values of first battery temperature sensor 351 to sixth battery temperature sensor 356, respectively. Each horizontal axis in Figs. 10 (A) to (F) represents time.

Fig. 10 (A) shows a relationship between the output value of first battery temperature sensor 351 and time, where LN7 in Fig. 10 indicates an example of a temporal change in the output value of first battery temperature sensor 351. Fig. 10 (B) shows a relationship between the output value of second battery temperature sensor 352 and time, where LN8 in Fig. 10 indicates an example of a temporal change in the output value of second battery temperature sensor 352. Fig. 10 (C) shows a relationship between the output value of third battery temperature sensor 353 and time, where LN9 in Fig. 10 indicates an example of a temporal change in the output value of third battery temperature sensor 353. Fig. 10 (D) shows a relationship between the output value of fourth battery temperature sensor 354 and time, where LN10 in Fig. 10 indicates an example of a temporal change in the output value of fourth battery temperature sensor 354. Fig. 10 (E) shows a relationship between the output value of fifth battery temperature sensor 355 and time, where LN11 in Fig. 10 indicates an example of a temporal change in the output value of fifth battery temperature sensor 355. Fig. 10 (F) shows a relationship between the output value of sixth battery temperature sensor 356 and time, where LN12 in Fig. 10 indicates an example of a temporal change in the output value of sixth battery temperature sensor 356.

For example, when the sixth amount of change exceeds a threshold value and none of the first amount of change to the fifth amount of change exceeds the threshold value at time T(0) as indicated by LN7 to LN12 in Fig. 10, control device 402 determines that the abnormality has occurred inside battery pack 100 because the predetermined change has occurred in fewer than two detection targets. At this time, control device 402 determines that the abnormality has occurred in the battery cell(s) in sixth region 366. The process then moves to S704.

In S704, control device 402 executes a notification process. For example, control device 402 transmits information about the occurrence and the location of the abnormality to a terminal of a user of vehicle 600. For example, control device 402 may read, from the storage device, information about the terminal of the user associated with the identification information of vehicle 600, and use the read information to transmit the information about the occurrence and the location of the abnormality to the terminal of the user. Alternatively, for example, control device 402 may transmit the information about the occurrence and the location of the abnormality to vehicle 600, or may cause an interface such as a display device of server 400 to display the information. The process then ends. When it is determined that the sensor information is not received (NO in S700), the process ends.

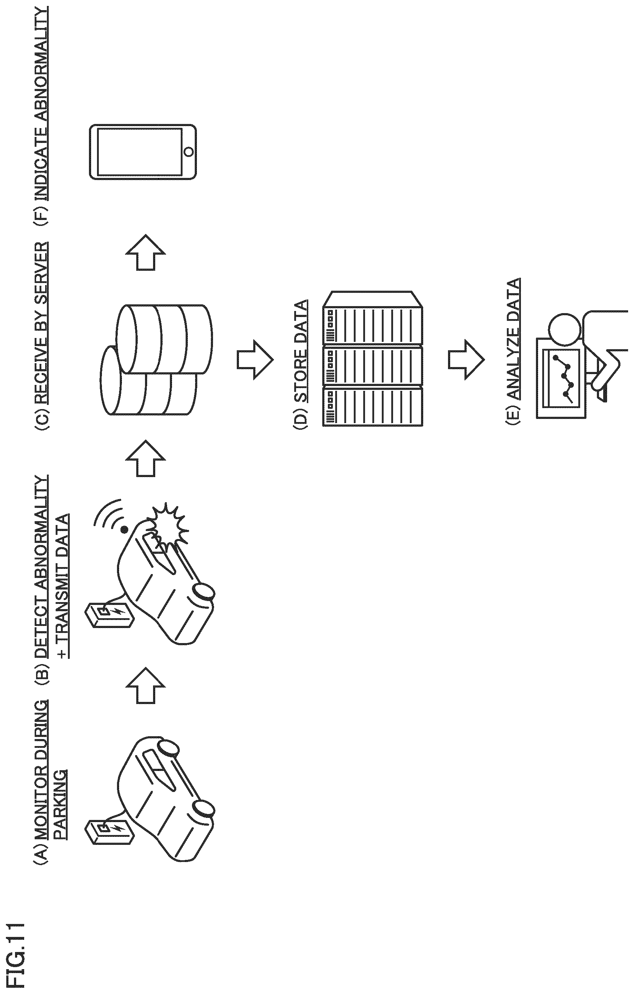

The operation of abnormality determination system 500 according to the present embodiment based on the above-described structure and flowchart is described with reference to Fig. 11. Fig. 11 is a diagram for illustrating the operation of abnormality determination system 500 according to the second embodiment.

As shown in Fig. 11 (A), let us assume that vehicle 600 is parked in a parking space, for example. At this time, battery pack 100 mounted on vehicle 600 is charged by connection of a connector of a charging station to vehicle 600. While vehicle 600 is parked, it is determined whether or not an abnormality has occurred using the result of detection by smoke exhaust unit temperature sensor 350 (S600). When it is determined that no abnormality has occurred (NO in S600), it is determined whether or not an abnormality has occurred upon each lapse of a predetermined amount of time (S600).

As shown in Fig. 11 (B), for example, when an abnormality (e.g., fire) occurs on the left rear side outside vehicle 600, the temperature of gas in the smoke exhaust unit within battery pack 100 increases due to generated heat, and therefore, the temperature detected by smoke exhaust unit temperature sensor 350 also increases. Then, when the detected temperature exceeds a threshold value, it is determined that an abnormality has occurred (YES in S600).

When it is determined that an abnormality has occurred, the predetermined electrical devices are activated (S602) to acquire the histories of output values of the battery temperature sensors, and the sensor information about the acquired various histories is transmitted to server 400 (S604). In vehicle 600, character information indicating the occurrence of the abnormality is displayed (S606).

When the sensor information is received by server 400 (YES in S700) as shown in Fig. 11 (C), the received sensor information is stored in the storage device of server 400 as shown in Fig. 11 (D). As shown in Fig. 11 (E), the stored sensor information is subjected to an analysis process and used to identify a location of the abnormality (S702).

For example, when the location of the abnormality is identified, the location is displayed on the display device in server 400, or, as shown in Fig. 11 (F), information about the location of the abnormality is transmitted to the terminal of the user of vehicle 600 (S704).

As described above, in abnormality determination system 500 according to the present embodiment, when it is determined that an abnormality has occurred in vehicle 600 using the result of detection by smoke exhaust unit temperature sensor 350, the histories of results of detection by the battery temperature sensors are transmitted to server 400. It is thus possible for server 400 to determine with high accuracy whether the abnormality that has occurred in vehicle 600 has occurred inside battery pack 100 or outside vehicle 600. Therefore, there can be provided an abnormality determination system, an abnormality determination method, a vehicle, and a server capable of determining a cause of a temperature increase with high accuracy.

Modifications are described below.

The above embodiment has described control device 300 as executing, after transmitting the sensor information to server 400, the notification process of causing the display device to display character information or an image indicating the occurrence of the abnormality, however, for example, control device 300 may acquire information about the location of the abnormality from server 400 and cause the display device to display character information or an image indicating the acquired location, or control device 300 may identify the location of the abnormality using the sensor information and cause the display device to display character information or an image indicating the identified location.

Further, the above embodiment has described an example in which it is determined whether or not an abnormality has occurred using the result of detection by smoke exhaust unit temperature sensor 350, however, any sensor may be used that detects the temperature of a detection target which increases in temperature both when an abnormality occurs inside battery pack 100 and when an abnormality occurs outside vehicle 600, which is not particularly limited to smoke exhaust unit temperature sensor 350. For example, instead of smoke exhaust unit temperature sensor 350, an outside air temperature sensor (not shown) that detects the outside air temperature of vehicle 600 may be used.

Further, the above embodiment has described server 400 as determining whether the abnormality has occurred inside battery pack 100 or outside vehicle 600, however, any one of the ECUs in control device 300 of vehicle 600 may make the determination.

Further, the above embodiment has described an example in which the battery temperature sensors are formed by six sensors provided at six locations of battery pack 100, however, at least two or more sensors should only be used, and the manner of use is not particularly limited to the use of six sensors.

Further, in the above embodiment, the positions where the battery temperature sensors are provided are not particularly limited to those shown in Fig. 7, as long as they are provided in the respective regions.

Further, the above embodiment has described an example in which the rectangular region of battery pack 100 as seen from above is set, and it is determined whether the abnormality has occurred inside battery pack 100 or outside vehicle 600 using the sensor provided in each of the six regions obtained by the division of the set rectangular region, however, it may be determined whether the abnormality has occurred inside battery pack 100 or outside vehicle 600 using five or less sensors or seven more sensors in the six regions. For example, it may be determined whether the abnormality has occurred inside battery pack 100 or outside vehicle 600 using the sensors provided in the first region on the right front side, the fourth region on the left front side, the third region on the right rear side, and the sixth region on the left rear side of the six regions in the direction of travel of vehicle 600.

Further, the above embodiment has described an example in which the rectangular region of battery pack 100 as seen from above is set, and the set rectangular region is divided into six regions, however, for example, a region corresponding to the outline of battery pack 100 as seen from above may be set, and the set region may be divided into a predetermined number of regions. For example, a region corresponding to the outline of battery pack 100 as seen from above may be divided into three front, center, and rear regions each having a predetermined shape such as a circular shape, and it may be determined whether the abnormality has occurred inside battery pack 100 or outside vehicle 600 using sensors provided in the divided regions.

Further, the above embodiment has described the battery temperature sensors as detecting the temperatures of the six regions, however, for example, another quantity of state may be used to estimate each of the temperatures of the six regions, and each estimated temperature may be acquired as the temperature of each of the six regions. The another quantity of state may be, for example, the temperature of a component adjacent to the six regions, or the amounts of heat generated and dissipated by the battery pack.

The modifications described above may be implemented in the form of being wholly or partially combined as appropriate.

Although the embodiments of the present disclosure have been described, it should be understood that the embodiments disclosed herein are illustrative and non-restrictive in every respect. The scope of the present disclosure is defined by the terms of the claims, and is intended to include any modifications within the scope and meaning equivalent to the terms of the claims.

## Claims

1. An abnormality determination system comprising:
a battery pack (100);
a first acquisition device (351) that acquires a first temperature indicating a temperature of a first region (361) of the battery pack;
a second acquisition device (354) that acquires a second temperature indicating a temperature of a second region (364) different from the first region (361); and
a control device (402) that determines whether an abnormality has occurred inside or outside the battery pack (100) using information about a history of the first temperature and a history of the second temperature.

2. The abnormality determination system according to claim 1, wherein
when a predetermined change occurs in each of the first temperature and the second temperature, the control device (402) determines that the abnormality has occurred outside the battery pack (100), and
when the predetermined change occurs in one of the first temperature and the second temperature, the control device (402) determines that the abnormality has occurred inside the battery pack (100).

3. The abnormality determination system according to claim 1, further comprising a third acquisition device (353) that acquires a third temperature indicating a temperature of a third region (363) of the battery pack (100), wherein
when a number of the first temperature, the second temperature and the third temperature in which a predetermined change has occurred exceeds a predetermined value, the control device (402) determines that the abnormality has occurred outside the battery pack (100), and
when the number of the temperatures in which the predetermined change has occurred is smaller than or equal to the predetermined value, the control device (402) determines that the abnormality has occurred inside the battery pack (100).

4. The abnormality determination system according to claim 3, wherein
when the number of the first temperature, the second temperature and the third temperature in which the predetermined change has occurred exceeds the predetermined value, the control device (402) identifies a location of the abnormality outside the battery pack (100) using a position of an acquisition device in which the predetermined change has occurred among the first acquisition device (351), the second acquisition device (354) and the third acquisition device (353).

5. The abnormality determination system according to any one of claims 2 to 4, wherein
the predetermined change includes a change greater than or equal to a predetermined value in a predetermined time period.

6. The abnormality determination system according to claim 3, further comprising a fourth acquisition device (356) that acquires a fourth temperature indicating a temperature of a fourth region (366) of the battery pack (100), wherein
the first region (361) is a region on a right front side of the battery pack (100) in a direction of travel of a vehicle,
the second region (364) is a region on a left front side of the battery pack (100) in the direction of travel,
the third region (363) is a region on a right rear side of the battery pack (100) in the direction of travel, and
the fourth region (366) is a region on a left rear side of the battery pack (100) in the direction of travel.

7. The abnormality determination system according to claim 1, wherein
the first acquisition device (351) and the second acquisition device (354) are mounted on a vehicle (600),
the control device (402) is provided in a server (400) capable of communicating with the vehicle (600), and
when an abnormality occurs in the vehicle (600), the vehicle (600) transmits information about the first temperature and the second temperature to the server (400).

8. An abnormality determination system that determines whether an abnormality has occurred inside or outside a battery pack (100) using a first temperature indicating a temperature of a first region of the battery pack (100), and a second temperature indicating a temperature of a second region different from the first region.

9. A vehicle comprising:
a battery pack (100);
a first acquisition device (351) that acquires a first temperature indicating a temperature of a first region (361) of the battery pack (100);
a second acquisition device (354) that acquires a second temperature indicating a temperature of a second region (364) different from the first region (361); and
a control device (300) that transmits information about a history of the first temperature and a history of the second temperature to a server (400).

10. An abnormality determination method for determining an abnormality in a battery pack (100), the abnormality determination method comprising:
acquiring a first temperature indicating a temperature of a first region (361) of the battery pack (100);
acquiring a second temperature indicating a temperature of a second region (364) different from the first region (361); and
determining whether an abnormality has occurred inside or outside the battery pack (100) using information about a history of the first temperature and a history of the second temperature.

11. A server comprising:
an acquisition device (404) that acquires, from a vehicle (600) having a battery pack (100) mounted thereon, information including a first temperature indicating a temperature of a first region (361) of the battery pack (100), and a second temperature indicating a temperature of a second region (364) different from the first region (361); and
a control device (402) that determines whether an abnormality has occurred inside the battery pack (100) or outside the vehicle (600) using the acquired first temperature and the acquired second temperature.
